(19) Europäisches Patentamt
European Patent Office
Office européen des brevets

(11) **EP 4 425 535 A1**

(12) **EUROPEAN PATENT APPLICATION**
published in accordance with Art. 153(4) EPC

(43) Date of publication:
04.09.2024 Bulletin 2024/36

(21) Application number: 22886565.5

(22) Date of filing: 28.09.2022

(51) International Patent Classification (IPC):
*H01L 21/3205* (2006.01)   *H01L 21/768* (2006.01)
*H01L 23/522* (2006.01)   *H01L 27/146* (2006.01)

(52) Cooperative Patent Classification (CPC):
H01L 21/3205; H01L 21/768; H01L 23/522;
H01L 27/146

(86) International application number:
PCT/JP2022/036110

(87) International publication number:
WO 2023/074233 (04.05.2023 Gazette 2023/18)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 26.10.2021 JP 2021174590

(71) Applicant: **Sony Semiconductor Solutions Corporation**
**Atsugi-shi, Kanagawa 243-0014 (JP)**

(72) Inventor: **HATANO, Keisuke**
**Atsugi-shi, Kanagawa 243-0014 (JP)**

(74) Representative: **MFG Patentanwälte**
**Meyer-Wildhagen Meggle-Freund**
**Gerhard PartG mbB**
**Amalienstraße 62**
**80799 München (DE)**

(54) **SEMICONDUCTOR DEVICE, METHOD FOR PRODUCING SAME, AND ELECTRONIC DEVICE**

(57)   To provide a semiconductor device, a manufacturing method therefor, and an electronic apparatus that can be applied to a chip-scale package-type solid-state imaging device that reduces a parasitic capacitance generated between an internal electrode and a board silicon so as to suppress waveform distortion and signal delay of high-frequency signals, thereby enabling a high-speed operation. A configuration to include: a board silicon; a silicon oxide film stacked on the board silicon; an inter-wiring-layer film having an internal electrode stacked on the silicon oxide film; a through-hole forming a stepped hole with a larger-diameter hole extending from the board silicon to the silicon oxide film and a smaller-diameter hole extending from the silicon oxide film to the internal electrode; an interlayer dielectric film stacked on a circumferential side surface of the larger-diameter hole and the board silicon; and a redistribution layer formed on an inner peripheral surface of the through-hole and the interlayer dielectric film and connected to the internal electrode is employed.

FIG.1

EP 4 425 535 A1

## Description

Technical Field

The present disclosure relates to a semiconductor device such as a solid-state imaging device, a manufacturing method therefor, and an electronic apparatus using the semiconductor device.

Background Art

In recent years, semiconductor devices used especially for mobile phones and the like have been increasingly downsized along with reductions in size and weight of electronic apparatuses. Accordingly, chip-scale packages have been employed for structures of semiconductor devices such as solid-state imaging devices in order to downsize camera modules.

In such a chip-scale package-type solid-state imaging device, for example, a logic board such as a driving element is bonded to a back surface of a sensor board. Imaging signals from imaging elements are captured by a logic circuit of the logic board. Moreover, a through-hole extending from a lower part of the logic board to an internal electrode is formed. Imaging signals processed on the logic circuit are transmitted to an external connection terminal by a redistribution layer through the through-hole from the internal electrode. A wire structure that allows input/output of signals is thus formed.

In the structure as described above that transmits the imaging signals to the external connection terminal from the back surface of the logic board by the use of a through-electrode, a board silicon forming the logic board and the internal electrode are electrically isolated from each other with a dielectric film. However, in such a wire structure, a parasitic capacitance is generated between the internal electrode and the board silicon. There is a problem in that this parasitic capacitance causes waveform distortion or signal delay of high-frequency signals, which makes it difficult to operate solid-state imaging elements at high speed.

In view of such a problem, the following technology associated with the solid-state imaging device has been disclosed. Specifically, the solid-state imaging device includes an imaging element formed on a first major surface of a board silicon, an external connection terminal such as a solder ball formed on a second major surface opposite to the first major surface of the board silicon, a dielectric film formed in a through-hole formed in the board silicon, a through-electrode formed on the dielectric film in the through-hole and electrically connected to the external connection terminal, and an internal electrode formed on the through-electrode on the first major surface of the board silicon.

Moreover, when viewed from a direction perpendicular to the first major surface of the board silicon, an outer shape with which the dielectric film is the board silicon is in contact is formed to be larger than an outer shape of the internal electrode.

That is, in short, the technology according to the present disclosure achieves a reduction in the parasitic capacitance between the internal electrode and the board silicon by forming the dielectric film between the internal electrode and the board silicon to be thicker.

Citation List

Patent Literature

Patent Literature 1: Japanese Patent Application Laid-open No. 2010-251558

Disclosure of Invention

Technical Problem

However, the technology disclosed by Patent Literature 1 reduces the capacitance between the redistribution layer and the board silicon by forming the dielectric film to be thicker on a through-hole side wall portion as described above. There is a problem that such a configuration leads to a cost increase because it is necessary to add a step of forming the thicker dielectric film on a circumferential side surface of the through-hole after the through-hole is opened.

Moreover, in view of the fact that the size of the through-hole is in the order of several tens of $\mu$m, it is necessary to form a very thick film thickness, in the order of several tens of $\mu$m, on the circumferential side surface of the through-hole. However, there is a problem that depositing the film with this thickness in a wafer process for the semiconductor cannot be a realistic manufacturing method in considerations of costs, difficulty, and the like because the wafer process takes time.

The present disclosure has been made in view of the above-mentioned problems and it is an objective thereof to provide a semiconductor device, a manufacturing method therefor, and an electronic apparatus that can be applied to a chip-scale package-type solid-state imaging device that reduces a parasitic capacitance generated between an internal electrode and a board silicon so as to suppress waveform distortion and signal delay of high-frequency signals, thereby enabling a high-speed operation.

Solution to Problem

The present disclosure has been made in order to solve the above-mentioned problems. A first aspect thereof is a semiconductor device including: a board silicon; a silicon oxide film stacked on the board silicon; an inter-wiring-layer film having an internal electrode stacked on the silicon oxide film; a through-hole forming a stepped hole with a larger-diameter hole extending from the board silicon to the silicon oxide film and a smaller-diameter hole extending from the silicon oxide film to the internal electrode; an interlayer dielectric film stacked on a circumferential side surface of the larger-diameter hole and the board silicon; and a redistribution layer formed on an inner peripheral surface of the through-hole and the interlayer dielectric film and connected to the internal electrode.

Moreover, in the first aspect, a circumferential side surface of the smaller-diameter hole may be held in close contact with a through-portion of the silicon oxide film.

Moreover, in the first aspect, the internal electrode may be formed of a copper film.

Moreover, in the first aspect, a plurality of slits may be formed in the internal electrode.

Moreover, in the first aspect, the internal electrodes in at least two layers may be stacked inside the inter-wiring-layer film.

Moreover, in the first aspect, the plurality of internal electrodes stacked inside the inter-wiring-layer film may be stacked in such a manner that the slits do not overlap each other.

Moreover, in the first aspect, a connection surface between the smaller-diameter hole and the internal electrode may be formed in a circular shape.

Moreover, in the first aspect, a connection surface between the smaller-diameter hole and the internal electrode may be formed in a rectangular shape.

Moreover, in the first aspect, the redistribution layer may have a solder bump provided at an opening of the through-hole.

Moreover, in first to third aspects, the semiconductor device may be a solid-state imaging device.

A second aspect thereof is a manufacturing method for a semiconductor device including: a step of stacking a silicon oxide film on a board silicon and stacking an inter-wiring-layer film having an internal electrode on the silicon oxide film; a step of forming a through-hole that is a stepped hole with a larger-diameter hole extending from the board silicon to the silicon oxide film and a smaller-diameter hole extending from the silicon oxide film to the internal electrode; a step of forming an interlayer dielectric film on a circumferential side surface of the through-hole of the board silicon and the board silicon; a step of forming a redistribution layer on an inner peripheral surface of the through-hole and the interlayer dielectric film; and a step of covering the interlayer dielectric film, the redistribution layer, and the through-hole with a protective film.

Moreover, in the second aspect, the step of stacking the silicon oxide film on the board silicon may include a step of forming a silicon oxide film-removed region that is a region where the smaller-diameter hole is formed in the silicon oxide film.

Moreover, in the second aspect, the step of forming the redistribution layer may include a step of providing a solder bump to the redistribution layer at an opening of the through-hole.

Moreover, in the second aspect, the step of forming the inter-wiring-layer film having the internal electrode may include a step of stacking the internal electrodes in a plurality of layers.

Moreover, in the second aspect, the step of forming the inter-wiring-layer film having the internal electrode may include a step of forming a slot portion in the inter-wiring-layer film, a step of depositing a copper film on a surface in which the slot portion is formed, and a step of polishing a surface in which the slot portion is formed in such a manner that the copper film remains in the slot portion.

A third aspect thereof is an electronic apparatus including a semiconductor device including a board silicon, a silicon oxide film stacked on the board silicon, an inter-wiring-layer film having an internal electrode stacked on the silicon oxide film, a through-hole forming a stepped hole with a larger-diameter hole extending from the board silicon to the silicon oxide film and a smaller-diameter hole extending from the silicon oxide film to the internal electrode, an interlayer dielectric film stacked on a circumferential side surface of the larger-diameter hole and the board silicon, and a redistribution layer that is formed on an inner peripheral surface of the through-hole and the interlayer dielectric film and is connected to the internal electrode.

By taking the above-mentioned aspects, it is possible to provide a semiconductor device, a manufacturing method therefor, and an electronic apparatus that can be applied to a chip-scale package-type solid-state imaging device that reduces a parasitic capacitance generated between an internal electrode and a board silicon so as to suppress waveform distortion and signal delay of high-frequency signals, thereby enabling a high-speed operation.

Brief Description of Drawings

[Fig. 1] A partial cross-sectional view showing a schematic structure of a solid-state imaging device associated with an example of the present disclosure.
[Fig. 2] A partial cross-sectional view showing a schematic structure of a through-hole portion in a first embodiment of the solid-state imaging device associated with the example of the present disclosure.
[Fig. 3] An explanatory diagram of a first manufacturing method for the first embodiment of the solid-state imaging device associated with the example of the present disclosure (Part 1).
[Fig. 4] An explanatory diagram of the first manufacturing method for the first embodiment of the solid-state imaging device associated with the example of the present disclosure (Part 2).
[Fig. 5] An explanatory diagram of the first manufacturing method for the first embodiment of the solid-state imaging device associated with the example of the present disclosure (Part 3).

[Fig. 6] An explanatory diagram of the first manufacturing method for the first embodiment of the solid-state imaging device associated with the example of the present disclosure (Part 4).

[Fig. 7] An explanatory diagram of the first manufacturing method for the first embodiment of the solid-state imaging device associated with the example of the present disclosure (Part 5).

[Fig. 8] A schematic plan view showing an arrangement example of a silicon oxide film-removed region in the first embodiment of the solid-state imaging device associated with the example of the present disclosure.

[Fig. 9] A schematic plan view showing another arrangement example of the silicon oxide film-removed region in the first embodiment of the solid-state imaging device associated with the example of the present disclosure.

[Fig. 10] An explanatory diagram of a second manufacturing method for the first embodiment of the solid-state imaging device associated with the example of the present disclosure (Part 1).

[Fig. 11] An explanatory diagram of the second manufacturing method for the first embodiment of the solid-state imaging device associated with the example of the present disclosure (Part 2).

[Fig. 12] An explanatory diagram of the second manufacturing method for the first embodiment of the solid-state imaging device associated with the example of the present disclosure (Part 3).

[Fig. 13] An explanatory diagram of the second manufacturing method for the first embodiment of the solid-state imaging device associated with the example of the present disclosure (Part 4).

[Fig. 14] An explanatory diagram of the second manufacturing method for the first embodiment of the solid-state imaging device associated with the example of the present disclosure (Part 5).

[Fig. 15] A partial cross-sectional view showing a schematic structure of a through-hole portion in a second embodiment of the solid-state imaging device associated with the example of the present disclosure.

[Fig. 16] A plan view showing a structure of a first-layer internal electrode in the second embodiment of the solid-state imaging device associated with the example of the present disclosure.

[Fig. 17] A plan view showing a structure of a second-layer internal electrode in the second embodiment of the solid-state imaging device associated with the example of the present disclosure.

[Fig. 18] An explanatory diagram of a manufacturing method for the first-layer internal electrode and the second-layer internal electrode in the second embodiment of the solid-state imaging device associated with the example of the present disclosure.

[Fig. 19] An explanatory diagram of a manufacturing method for the second embodiment of the solid-state imaging device associated with the example of the present disclosure (Part 1).

[Fig. 20] An explanatory diagram of the manufacturing method for the second embodiment of the solid-state imaging device associated with the example of the present disclosure (Part 2).

[Fig. 21] An explanatory diagram of the manufacturing method for the second embodiment of the solid-state imaging device associated with the example of the present disclosure (Part 3).

[Fig. 22] An explanatory diagram of the manufacturing method for the second embodiment of the solid-state imaging device associated with the example of the present disclosure (Part 4).

[Fig. 23] An explanatory diagram of the manufacturing method for the second embodiment of the solid-state imaging device associated with the example of the present disclosure (Part 5).

[Fig. 24] A block diagram showing a configuration example of an electronic apparatus including the solid-state imaging device associated with the example of the present disclosure.

[Fig. 25] A partial cross-sectional view showing a comparative example regarding the structure of the solid-state imaging device. Mode(s) for Carrying Out the Invention

Next, modes for carrying out the present disclosure (hereinafter, referred to as "embodiments") will be described with reference to the drawings in the following order. In the drawings described below, the same or similar portions are denoted by the same or similar reference signs. It should be noted that the drawings are schematic, and scales and the like of the respective parts are not necessarily identical to those in reality. Moreover, it is needless to say that the dimension relations and scales are partially different also between the drawings.

1. First Embodiment of Solid-State Imaging Device Associated with Example of Present Disclosure
2. First Manufacturing Method for First Embodiment of Solid-State Imaging Device Associated with Example of Present Disclosure
3. Second Manufacturing Method for First Embodiment of Solid-State Imaging Device Associated with Example of Present Disclosure
4. Second Embodiment of Solid-State Imaging Device Associated with Example of Present Disclosure
5. First Manufacturing Method for Second Embodiment of Solid-State Imaging Device Associated with Example of Present Disclosure
6. Second Manufacturing Method for Second Embodiment of Solid-State Imaging Device Associated with Example of Present Disclosure
7. Configuration Example of Electronic Apparatus

<1. First Embodiment of Solid-State Imaging Device Associated with Example of Present Disclosure>

[Configuration of First Embodiment]

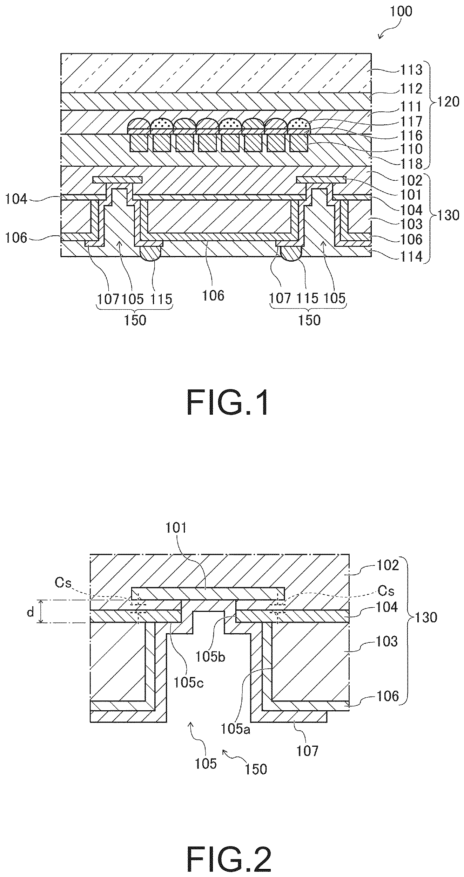

Hereinafter, a first embodiment of a semiconductor device according to the present disclosure will be described with reference to Fig. 1 using a solid-state imaging device 100 as an example (hereinafter, referred to as a "solid-state imaging device associated with the example of the present disclosure" when the description is given using the solid-state imaging device as an example as the embodiment). This figure is a partial cross-sectional view showing a schematic structure of the first embodiment of the solid-state imaging device 100 associated with the example of the present disclosure. As shown in the figure, the solid-state imaging device 100 is formed in such a manner that a logic board 130 on which a driving element that processes imaging signals and a logic circuit including a wire layer and the like are arranged is bonded to a lower surface of a sensor board 120.

As shown in Fig. 1, for example, a photoelectric converter 110 including a plurality of photodiodes is provided in a photodiode forming layer 118 of the sensor board 120. Moreover, color filters 116 are stacked on an upper surface of the photoelectric converter 110, which is on a light incident surface side of the solid-state imaging device 100. On-chip lenses 117 are stacked on upper surfaces of the color filters 116.

In addition, a dielectric film 111 is formed and flattened on upper surfaces of the On-chip lenses 117. Moreover, a light-transmissive substrate 113 such as a glass is bonded on an upper surface of the dielectric film 111 via a bonding resin 112. It should be noted that in the following description, the word "upper" of the "upper surface" and the like and the word "lower" of the "lower surface" and the like refer to "upper" and "lower" in the drawings, respectively.

The logic board 130 is a board for forming a logic circuit for sequentially reading out pixel data for each pixel generated at the photoelectric converter 110. The logic circuit is constituted by, for example, a vertical drive unit, a horizontal drive unit, a system control unit, a signal processing unit, and the like (all of them are not shown) and connection of the logic circuit is performed in an inter-wiring-layer film 102.

The logic board 130 is formed by stacking a silicon oxide film 104 on an upper surface of a board silicon 103 and stacking the inter-wiring-layer film 102 on an upper surface of the silicon oxide film 104. Moreover, internal electrodes 101 connected to wires of the logic circuit are stacked on the inter-wiring-layer film 102. In a lower surface of the logic board 130, through-hole portions 150 penetrating the board silicon 103 with respect to the internal electrodes 101 are provided. The through-hole portions 150 include through-holes 105, solder bumps 115, and redistribution layers 107. Moreover, the through-hole portions 150 are formed to be capable of inputting/outputting signals from the logic circuit to the outside through the through-holes 105.

In each of the through-hole portions 150, the through-hole 105 that is a stepped hole that penetrates the silicon oxide film 104 from below the board silicon 103 and reaches the internal electrode 101 is formed. Moreover, an interlayer dielectric film 106 is provided between a circumferential side surface of the through-hole 105 and a lower surface of the board silicon 103, thereby ensuring insulation. Moreover, the redistribution layers 107 that cover a lower surface of the interlayer dielectric film 106 with electrically conductive metal such as copper (Cu) are formed and electrically connect the through-holes 105 to the lower surfaces of the internal electrodes 101.

Moreover, the redistribution layers 107 at the openings of the through-holes 105 are widely formed and the solder bumps 115 each having a substantially hemisphere shape, which are external connection terminals, are provided. In addition, the interlayer dielectric film 106, the redistribution layers 107, and the through-holes 105 are covered with a protective film 114, thereby ensuring insulation, and top portions of the solder bumps 115 are exposed. It should be noted that the through-hole 105 refers to a so-called through silicon via (TSV).

The solder bumps 115 are soldered to a printed board (not shown) of an electronic apparatus or the like in which this solid-state imaging device 100 is incorporated by reflow soldering, for example, and is connected to a circuit formed on the printed board.

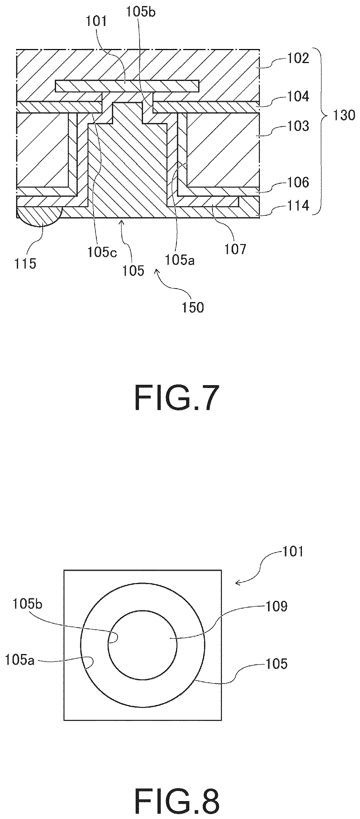

Figs. 2 and 7 are partial cross-sectional views each showing a schematic structure of the through-hole portion 150 in the first embodiment of the solid-state imaging device 100 associated with the example of the present disclosure. It should be noted that Fig. 2 is a view before the solder bump 115 and the protective film 114 are provided.

As shown in the figure, the logic board 130 is formed by stacking the silicon oxide film 104 on the upper surface of the board silicon 103 and further stacking the inter-wiring-layer film 102 on an upper surface of the silicon oxide film 104. Moreover, the through-hole portion 150 penetrating the board silicon 103 with respect to the internal electrode 101 is provided below the board silicon 103. That is, as the through-hole 105 of the through-hole portion 150, a larger-diameter hole 105a that penetrates the board silicon 103 from below the board silicon 103 and reaches the silicon oxide film 104 is formed. In addition, a smaller-diameter hole 105b that penetrates the silicon oxide film 104 and the inter-wiring-layer film 102 and reaches the internal electrodes 101 is formed. Accordingly, a stepped hole that forms a step portion 105c in the silicon oxide film 104 and reaches the internal electrodes 101 is formed as the through-hole 105.

Moreover, the interlayer dielectric film 106 is formed on a circumferential side surface of the larger-diameter hole 105a of the through-hole 105 and the lower surface of the board silicon 103. Therefore, the redistribution layer 107 is electrically insulated from the board silicon 103. The entire inner peripheral surface of the through-hole 105 and the interlayer dielectric film 106 are covered with electrically conductive metal such as copper (Cu). Accordingly, the internal electrode 101 is electrically connected to the redistribution layer 107 that covers the inner peripheral surface of the through-hole 105 and the interlayer dielectric film 106.

Moreover, the silicon oxide film 104 is stacked between the inter-wiring-layer film 102 and the board silicon 103 as described above. The portion where the smaller-diameter hole 105b penetrates the silicon oxide film 104 is held in close contact with a circumferential side surface of the smaller-diameter hole 105b.

Moreover, as shown in Figs. 1 and 7, the solder bumps 115 each having a substantially hemisphere shape, which are the external connection terminals, are provided on the redistribution layers 107 at the openings of the through-holes 105. In addition, the interlayer dielectric film 106, the redistribution layers 107, and the through-holes 105 are covered with the protective film 114, thereby ensuring insulation, and the top portions of the solder bumps 115 are exposed.

Alternatively, the interlayer dielectric film 106, the redistribution layers 107, and the through-holes 105 may be covered with the protective film 114 and land or wire patterns for external connection may be formed on the redistribution layers 107 at the openings of the through-holes 105.

Since the solid-state imaging device 100 that is an example of the semiconductor device according to the first embodiment is configured as described above, the inter-wiring-layer film 102 and the silicon oxide film 104 are provided between the internal electrode 101 and the board silicon 103. Therefore, as shown in Fig. 2, a distance d between the internal electrode 101 and the board silicon 103 in a portion where they face each other can be increased, and a parasitic capacitance Cs generated between both can be reduced. Therefore, it is possible to suppress signal delay and waveform distortion of high-frequency signals, and it is thus possible to realize high-speed operation.

As described hereinabove, the solid-state imaging device 100 associated with the example of the present embodiment has structural characteristics in that the stepped hole has the step portion 105c in the through-hole 105 whose inner peripheral surface is covered with the redistribution layer 107 and that the circumferential side surface of the smaller-diameter hole 105b penetrating the silicon oxide film 104 and a through-portion of the silicon oxide film 104 are held in close contact with each other.

[Reason Why Parasitic Capacitance Can Be Reduced]

Here, the parasitic capacitance Cs can be reduced by employing a configuration in which the through-hole 105 has the step portion 105c and the circumferential side surface of the smaller-diameter hole 105b penetrating the silicon oxide film 104 and the through-portion of the silicon oxide film 104 are held in close contact with each other as described above. The reason for this will be described below.

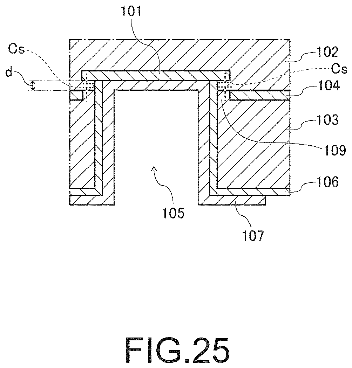

Fig. 25 is a partial cross-sectional view showing a comparative example to the present embodiment. It should be noted that Fig. 25 is a view before the solder bump 115 and the protective film 114 are provided. The configuration example shown in this figure is an example in which the through-hole 105 has no step portion 105c and the circumferential side surface of the through-hole 105 formed in the board silicon 103 and the through-portion of the silicon oxide film 104 are not held in close contact with each other. Moreover, such a structure is a generally-used structure. This comparative example is configured specifically as follows.

The silicon oxide film 104 is first stacked on the board silicon 103. A silicon oxide film-removed region 109 is formed in the silicon oxide film 104. In the silicon oxide film-removed region 109, no silicon oxide film 104 is arranged in a region where the through-hole 105 is formed. Next, the inter-wiring-layer film 102 is stacked on the silicon oxide film 104. The internal electrode 101 is formed inside the inter-wiring-layer film 102. The internal electrode 101 is a receiver for the through-hole 105 for electrically connecting to the redistribution layer 107 from below the board silicon 103.

Here, it is advantageous that the silicon oxide film-removed region 109 is formed to be slightly larger so as not to interfere with the through-hole 105 in order to form the through-hole 105 in such a manner that it reaches the internal electrode 101. Moreover, the internal electrode 101 is formed to be larger than the diameter of the through-hole 105 because it is necessary to prevent the internal electrode 101 from being misaligned with the through-hole 105 during the manufacture and it is also necessary to connect the internal electrode 101 to other internal wires.

In addition, the through-hole 105 does not have the step portion 105c. Therefore, the through-hole 105 formed under such a limitation has a structure as shown in Fig. 25. That is, a structure in which the circumferential side surface of the through-hole 105 is not held in close contact with the through-portion of the silicon oxide film 104 and the board silicon 103 is provided between them is provided.

Then, as shown in the figure, the parasitic capacitance Cs is generated between a circumferential portion of the internal electrode 101 and an outer peripheral portion of the through-hole 105 of the board silicon 103.

Here, the magnitude of the parasitic capacitance Cs is expressed as follows.

$$Cs = \varepsilon S/d$$

In the above expression, $\varepsilon$ denotes permittivity between the internal electrode 101 and the board silicon 103 (air permittivity so is about $8.854 \times 10^{-12}$ F/m. Moreover, permittivity of silicon (Si) is about 12 times as large as the air permittivity $\varepsilon_0$.), S denotes an area of a portion where the internal electrode 101 and the board silicon 103 face each other, and d denotes a distance of the portion where the internal electrode 101 and the board silicon 103 face each other.

Therefore, in accordance with the above expression, the magnitude of the parasitic capacitance Cs is proportional to an area S of the portion where the internal electrode 101 and the board silicon 103 face each other and is inversely proportional to the distance d of the portion where the internal electrode 101 and the board silicon 103 face each other.

Therefore, the area S of the portion where the internal electrode 101 and the board silicon 103 face each other only needs to be reduced in order to reduce the parasitic capacitance Cs. Alternatively, the distance d only needs to be increased. As a matter of course, both may be performed.

However, in considerations of the misalignment during the manufacture, there is a limitation on reduction of the area S of the portion where the internal electrode 101 and the board silicon 103 face each other. In view of this, the present embodiment achieves reduction of the parasitic capacitance Cs by increasing the distance d of the portion where the internal electrode 101 and the board silicon 103 face each other.

That is, in the comparative example shown in Fig. 25, only the inter-wiring-layer film 102 is provided between the internal electrode 101 and the board silicon 103. On the other hand, as shown in Fig. 2, in the present embodiment, the inter-wiring-layer film 102 and the silicon oxide film 104 are provided between the internal electrode 101 and the board silicon 103. Therefore, the distance d of the portion where the internal electrode 101 and the board silicon 103 face each other can be increased in the present embodiment as compared to the comparative example shown in Fig. 25. Accordingly, it is possible to reduce the parasitic capacitance Cs.

As described above, in accordance with the present embodiment, in the solid-state imaging device 100 with a chip-scale package structure in which the internal electrodes 101 are connected to the redistribution layers 107 through the through-holes 105, the distance d of the portion where the internal electrode 101 and the board silicon 103 face each other can be increased in such a manner that the through-holes 105 are formed as stepped holes and the circumferential side surfaces of the smaller-diameter holes 105b are held in close contact with the through-portions of the silicon oxide film 104. Accordingly, it is possible to reduce the parasitic capacitance Cs. Therefore, it is possible to suppress signal delay and waveform distortion of high-frequency signals, and it is thus possible to realize high-speed operation.

<2. First Manufacturing Method for First Embodiment of Solid-State Imaging Device Associated with Example of Present Disclosure>

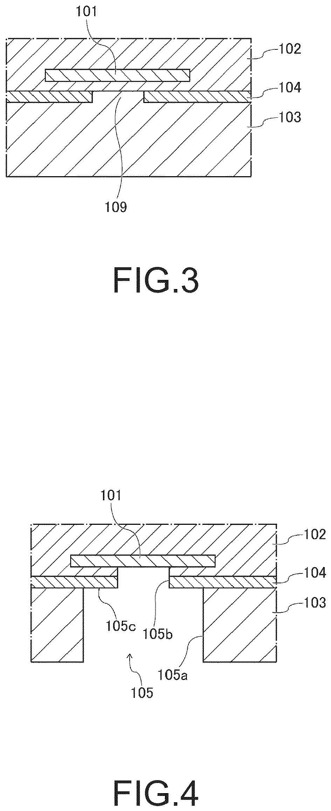

Next, a first manufacturing method for the first embodiment of the solid-state imaging device 100 associated with the example of the present disclosure will be described with reference to Figs. 3 to 7.

As shown in Fig. 3, the silicon oxide film 104 is first stacked on the board silicon 103. The silicon oxide film 104 is constituted by, for example, silicon dioxide ($SiO_2$). The silicon oxide film-removed region 109 where the silicon oxide film 104 is not arranged in the region in which the smaller-diameter hole 105b of the through-hole 105 is formed is formed in the silicon oxide film 104. The silicon oxide film-removed region 109 can be formed at the same time as the silicon oxide film 104 by an oxide film formation step used in shallow trench isolation (STI) (hereinafter, referred to as "STI") which is element separation on the logic board 130, for example. Accordingly, the silicon oxide film-removed region 109 is made of the same material as the board silicon 103.

Next, the inter-wiring-layer film 102 is stacked on the silicon oxide film 104. The internal electrode 101 which is the receiver for the through-hole 105 for electrically connecting to the redistribution layer 107 from below the board silicon 103 is formed inside the inter-wiring-layer film 102. For example, silicon dioxide is used for the base material of the inter-wiring-layer film 102 as in the silicon oxide film 104.

Next, as shown in Fig. 4, the through-hole 105 is formed toward the inter-wiring-layer film 102 from below the board silicon 103. As the through-hole 105, the larger-diameter hole 105a is formed to reach the silicon oxide film 104 in the board silicon 103. The larger-diameter hole 105a reaches the silicon oxide film 104, and then the smaller-diameter hole 105b is formed to reach the internal electrode 101 in the silicon oxide film-removed region 109. Accordingly, as the through-hole 105, the stepped hole having the step portion 105c in the silicon oxide film 104 can be formed. The larger-diameter hole 105a, the smaller-diameter hole 105b, and the stepped hole having the step portion 105c can be formed by patterning with resist and etching.

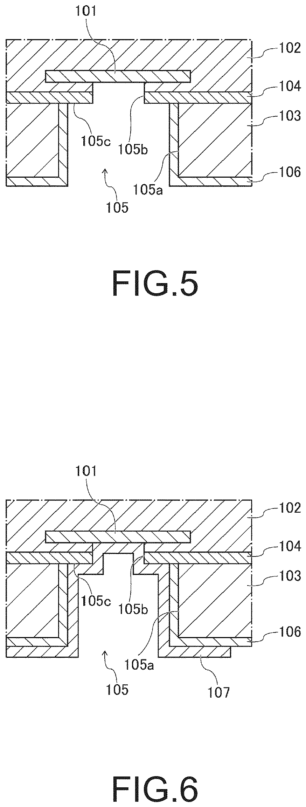

Next, as shown in Fig. 5, the interlayer dielectric film 106 is formed on the circumferential side surface of the larger-diameter hole 105a of the through-hole 105 and the lower surface of the board silicon 103. The interlayer dielectric film 106 first covers the entire lower surface of the board silicon 103 and the entire inner peripheral surfaces of the larger-diameter hole 105a and the smaller-diameter hole 105b with a dielectric film. After that, it can be formed by removing the dielectric film on the silicon oxide film 104 forming the step portion 105c and the dielectric film on the inner peripheral surface of the smaller-diameter hole 105b by a technique such as etching back.

Next, as shown in Fig. 6, the redistribution layer 107 is formed on the entire inner peripheral surface of the through-hole 105 and the interlayer dielectric film 106. As the redistribution layer 107 on the interlayer dielectric film 106, a mask is formed with a resist material provided with an opening pattern conforming to the shape of a wire pattern in a region where wires are formed and, for example, a copper film with a film thickness of from several $\mu$m to several tens of $\mu$m is formed by electroplating. Accordingly, the internal electrode 101 is electrically connected to the redistribution layer 107, such that pixel data can be transmitted to the outside through the through-hole 105.

Next, as shown in Fig. 7, the solder bump 115 which is the external connection terminal connected to an external module board (not shown) is provided on the redistribution layer 107 at the opening of the through-hole 105. Moreover, the interlayer dielectric film 106, the redistribution layer 107, and the through-hole 105 are covered with the protective film 114 and the top portion of the solder bump 115 is exposed. In this manner, the solid-state imaging device 100 according to the first embodiment can be manufactured. Alternatively, the interlayer dielectric film 106, the redistribution layer 107, and the through-hole 105 may be covered with the protective film 114 and land or wire patterns for external connection may be formed on the redistribution layer 107 at the opening of the through-hole 105.

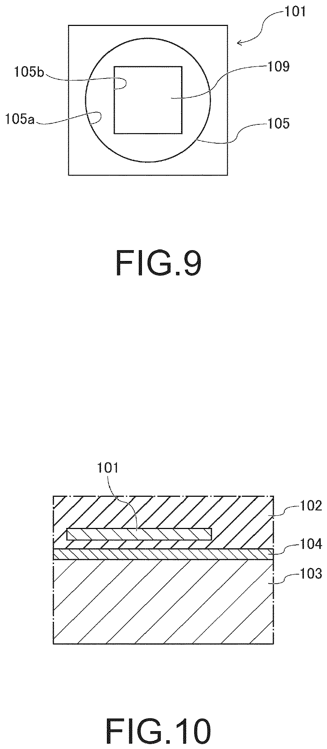

Here, a positional relation between the through-hole 105 in the solid-state imaging device 100 according to the first embodiment and the silicon oxide film-removed region 109 of the silicon oxide film 104 in which the smaller-diameter hole 105b is formed will be described with reference to schematic plan views of Figs. 8 and 9. Fig. 8 is a plan view showing an arrangement example of the larger-diameter hole 105a of the through-hole 105 and the silicon oxide film-removed region 109 of the silicon oxide film 104 in the first embodiment.

The silicon oxide film-removed region 109 is a region that the smaller-diameter hole 105b of the through-hole 105 penetrates. The size of the region corresponds to a connection surface between the smaller-diameter hole 105b reaching the lower surface of the internal electrode 101 and the internal electrode 101. That is, the internal electrode 101 is electrically connected by covering the inner peripheral surface of the smaller-diameter hole 105b reaching the lower surface of the internal electrode 101 with the redistribution layer 107.

The silicon oxide film-removed region 109 is provided in a concentric circle shape in the through-hole 105. The silicon oxide film-removed region 109 can be formed at the same time as the silicon oxide film 104 by the oxide film formation step used in the STI which is element separation of the logic board 130, for example.

Here, the diameter of the silicon oxide film-removed region 109 (i.e., the diameter of the smaller-diameter hole 105b of the through-hole 105) has no problem in view of connection resistance between the internal electrode 101 and the redistribution layer 107 as long as it is about 1/2 of the diameter of the through-hole 105 (i.e., the diameter of the larger-diameter hole 105a of the through-hole 105). The through-hole 105 generally has a diameter of about several tens of $\mu$m and has sufficiently low resistance as compared to the resistance of the redistribution layer 107.

Fig. 9 is a plan view showing another arrangement example of the through-hole 105 and the silicon oxide film-removed region 109 of the silicon oxide film 104 in the first embodiment. In this figure, the silicon oxide film-removed region 109 is formed in a rectangular shape at the center portion of the through-hole 105.

It should be noted that the shape of the silicon oxide film-removed region 109 is not limited to the circular shape described above with reference to Fig. 8, and can have any shape such as a triangle shape or a star shape other than the rectangular shape as shown in Fig. 9.

As described hereinabove, in accordance with the first manufacturing method for the first embodiment, the larger-diameter hole 105a is formed to reach the silicon oxide film 104, and then the smaller-diameter hole 105b is formed toward the internal electrode 101. Therefore, the through-hole 105 can be formed as the stepped hole having the step portion 105c.

Moreover, it is sufficient to entirely remove a base material forming the board silicon 103 in the silicon oxide film-removed region 109 by etching for the smaller-diameter hole 105b. Therefore, the circumferential side surface of the smaller-diameter hole 105b formed in the board silicon 103 can be held in close contact with the through-portion of the silicon oxide film 104. Accordingly, as shown in Fig. 2, the distance d of the portion where the internal electrode 101 and the board silicon 103 face each other can be increased, and the parasitic capacitance Cs generated between both can be reduced. Therefore, it is possible to suppress signal delay and waveform distortion of high-frequency signals, and it is thus possible to realize high-speed operation.

<3. Second Manufacturing Method for First Embodiment of Solid-State Imaging Device Associated with Example of Present Disclosure>

Next, a second manufacturing method for the first embodiment of the solid-state imaging device 100 associated with the example of the present disclosure will be described with reference to Figs. 10 to 14. The second manufacturing method for the present embodiment is different from the first manufacturing method for the first embodiment in that it does not include the step of forming the silicon oxide film-removed region 109.

As shown in Fig. 10, the silicon oxide film 104 is first stacked on the board silicon 103. The silicon oxide film 104 is constituted by, for example, silicon dioxide.

Next, the inter-wiring-layer film 102 is stacked on the silicon oxide film 104. The internal electrode 101 which is the receiver for the through-hole 105 for electrically connecting to the redistribution layer 107 from below the board silicon 103 is formed in the inter-wiring-layer film 102.

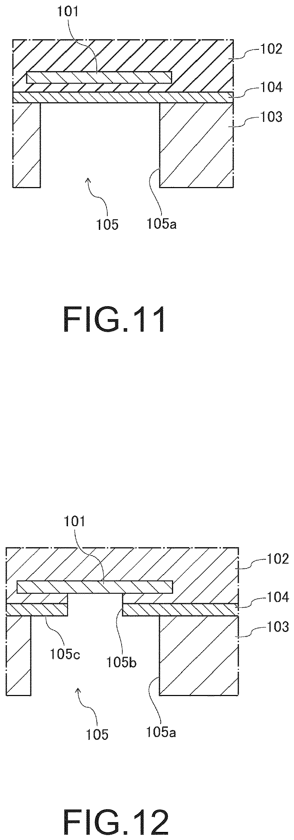

Next, as shown in Fig. 11, the through-hole 105 is formed toward the inter-wiring-layer film 102 from below the board silicon 103. The through-hole 105 is formed in such a manner that the larger-diameter hole 105a reaches the silicon oxide film 104 in the board silicon 103. Accordingly, the silicon oxide film 104 is exposed inside the through-hole 105.

Next, as shown in Fig. 12, the smaller-diameter hole 105b is formed to reach the internal electrode 101. Accordingly, the through-hole 105 is formed as the stepped hole having the step portion 105c in the silicon oxide film 104.

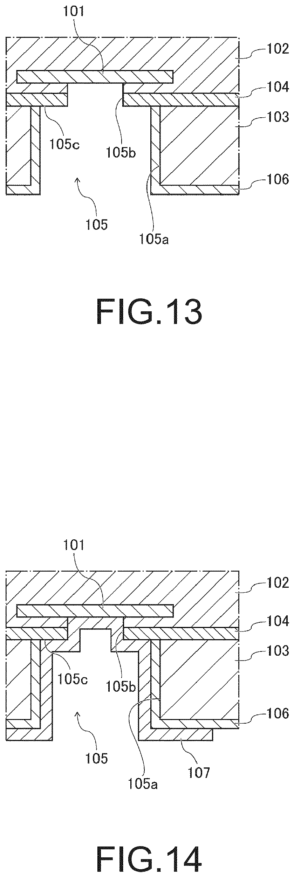

Next, as shown in Fig. 13, the interlayer dielectric film 106 is formed on the circumferential side surface of the larger-diameter hole 105a of the through-hole 105 and the lower surface of the board silicon 103. The interlayer dielectric film 106 first covers the entire lower surface of the board silicon 103 and the entire inner peripheral surfaces of the larger-diameter hole 105a and the smaller-diameter hole 105b with the dielectric film. After that, it can be formed by removing the dielectric film on the silicon oxide film 104 forming the step portion 105c and the inner peripheral surface of the smaller-diameter hole 105b by a technique such as etching back.

It should be noted that steps following this step are similar to those of the above-mentioned first manufacturing method for the first embodiment.

Next, as shown in Fig. 14, the redistribution layer 107 is formed. The step of forming the redistribution layer 107 is similar to that of the first manufacturing method for the first embodiment described above with reference to Fig. 6, and therefore the description will be omitted.

Next, the redistribution layer 107 at the opening of the through-hole 105 is provided with the solder bump 115 which is the external connection terminal. It is similar to that of the above-mentioned first manufacturing method for the first embodiment, and therefore the description will be omitted.

The solid-state imaging device 100 according to the first embodiment as shown in Fig. 7 can be manufactured by the steps as described above.

As described hereinabove, in accordance with the second manufacturing method for the first embodiment of the solid-state imaging device 100 associated with the example of the present disclosure, the smaller-diameter hole 105b is formed in the silicon oxide film 104 after the larger-diameter hole 105a is formed. Therefore, etching can be stopped once by using the silicon oxide film 104 as a stopper during etching working of the board silicon 103 whose worked film thickness is larger. Therefore, in the subsequent working to form the internal electrode 101, it is relatively easy to control the etching speed because the worked film thickness of the inter-wiring-layer film 102 is smaller. Therefore, it is possible to overcome problems such as lost of the internal electrode 101 due to overetching and to manufacture the solid-state imaging device 100 with more stable quality.

Moreover, in accordance with the second manufacturing method for the first embodiment, the through-hole 105 can be formed as the stepped hole having the step portion 105c. In addition, since the smaller-diameter hole 105b with a diameter smaller than the larger-diameter hole 105a is formed in the silicon oxide film 104, there is no room for the base material forming the board silicon 103 in the circumferential side surface of the smaller-diameter hole 105b formed in the silicon oxide film 104. Therefore, the circumferential side surface of the smaller-diameter hole 105b formed in the board silicon 103 can be held in close contact with the through-portion of the silicon oxide film 104. Accordingly, as shown in Fig. 2, the distance d of the portion where the internal electrode 101 and the board silicon 103 face each other can be increased, and the parasitic capacitance Cs generated between both can be reduced. Therefore, it is possible to suppress signal delay and waveform distortion of high-frequency signals, and it is thus possible to realize high-speed operation.

<4. Second Embodiment of Solid-State Imaging Device Associated with Example of Present Disclosure>

Next, a second embodiment of the solid-state imaging device 100 associated with the example of the present disclosure will be described. The present embodiment is different from the first embodiment in that the through-hole 105 is configured to be capable of connecting to internal electrodes in at least two layers.

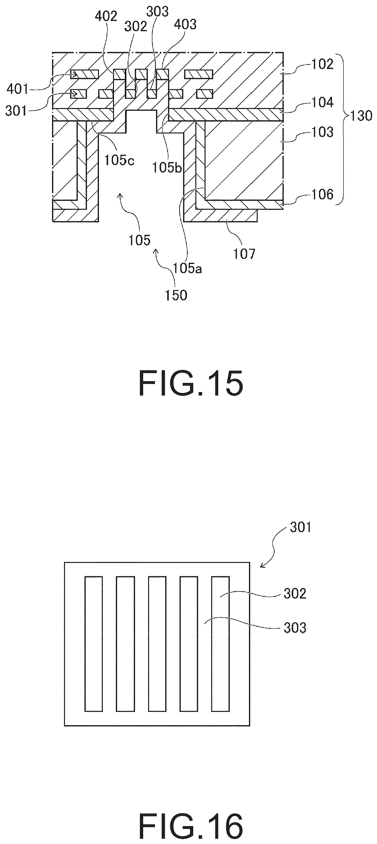

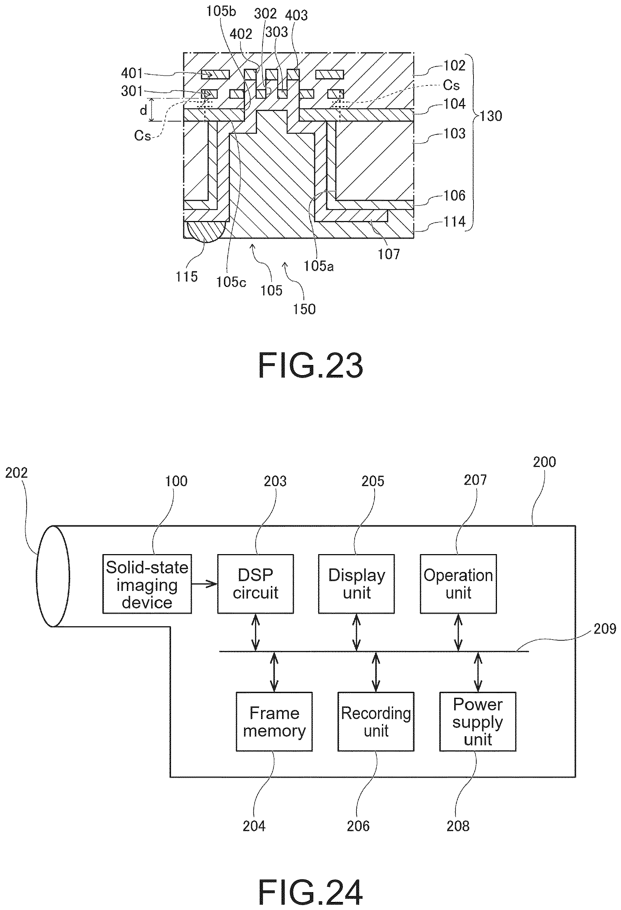

Figs. 15 and 23 are partial cross-sectional views showing schematic structures of the through-hole portion 150 according to the second embodiment of the solid-state imaging device 100 associated with the example of the present disclosure. It should be noted that Fig. 15 is a view before the solder bump 115 and the protective film 114 are provided.

As shown in the figure, the logic board 130 is formed by stacking the silicon oxide film 104 on the upper surface of the board silicon 103 and further stacking the inter-wiring-layer film 102 on an upper surface of the silicon oxide film 104. Inside the inter-wiring-layer film 102, a first-layer internal electrode 301 is stacked and a second-layer internal electrode 401 is further stacked above the first-layer internal electrode 301. Moreover, from below the board silicon 103, the through-hole portion 150 penetrating the board silicon 103 is provided with respect to the first-layer internal electrode 301 and the second-layer internal electrode 401.

As the through-hole 105 of the through-hole portion 150, the larger-diameter hole 105a that penetrates the board silicon 103 from below the board silicon 103 and reaches the silicon oxide film 104 is formed as shown in Fig. 15. In addition, the smaller-diameter hole 105b that penetrates the silicon oxide film 104 and the inter-wiring-layer film 102 and reaches the first-layer internal electrode 301 and the second-layer internal electrode 401 is formed.

Accordingly, as the through-hole 105, the stepped hole having the step portion 105c in the silicon oxide film 104 is formed. Moreover, the circumferential side surface of the smaller-diameter hole 105b is held in close contact with the through-portion of the silicon oxide film 104. Moreover, the interlayer dielectric film 106 is formed on the circumferential side surface of the larger-diameter hole 105a of the through-hole 105 and the lower surface of the board silicon 103. Moreover, the redistribution layer 107 is formed on the inner peripheral surface of the through-hole 105 and the interlayer dielectric film 106 with electrically conductive metal such as copper (Cu) and is connected to linear portions 303 in the first layer and linear portions 403 in the second layer. Therefore, the redistribution layer 107 is electrically insulated from the board silicon 103.

Moreover, as shown in Fig. 23, the redistribution layer 107 formed at the opening of the through-hole 105 is provided with the solder bump 115. It is similar to that of the above-mentioned first embodiment, and therefore the description will be omitted.

Regarding the first-layer internal electrode 301, as shown in Fig. 16, a plurality of slits 302 vertically long is formed in the thin plate substantially rectangular in plan view. Therefore, a linear portion 303 forming a straight line serving as a beam is formed between the slits 302 and 302 adjacent to each other. Accordingly, the slits 302 and the linear portions 303 are arranged in a stripe or grid pattern as a whole.

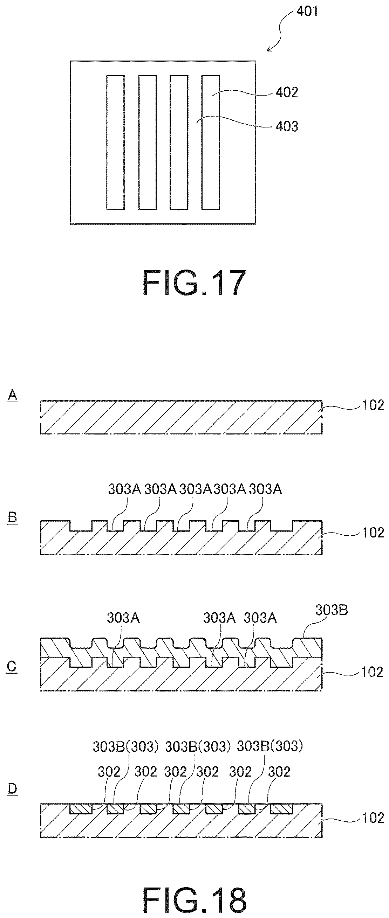

Regarding the second-layer internal electrode 401, as shown in Fig. 17, a plurality of slits 402 vertically long is formed in the thin plate substantially rectangular in plan view as in the first-layer internal electrode 301. Therefore, a linear portion 403 forming a straight line serving as a beam is formed between the slits 402 and 402 adjacent to each other. Accordingly, the slits 402 and the linear portions 403 are arranged in a stripe or grid pattern as a whole.

However, both do not have the same shape. When both are overlapped, the slits 302 of the first-layer internal electrode 301 and the slits 402 of the second-layer internal electrode 401 are alternately placed in such a manner that the slits 302 and 402 are respectively closed by the corresponding linear portions 403 and 303.

Therefore, as shown in a partial cross-sectional view of Fig. 15, the slits 302 of the first-layer internal electrode 301 and the slits 402 of the second-layer internal electrode 401 do not overlap each other and the linear portions 303 of the first-layer internal electrode 301 and the linear portions 403 of the second-layer internal electrode 401 do not overlap each other.

In view of this, the redistribution layer 107 is connected to the linear portions 303 of the first-layer internal electrode 301 formed in the inter-wiring-layer film 102 through the smaller-diameter hole 105b of the through-hole 105. Similarly, the redistribution layer 107 is connected to the linear portions 403 of the second-layer internal electrode 401 by passing through the slits 302 of the first-layer internal electrode 301.

It should be noted that in the present embodiment, the example in which the first-layer internal electrode 301 and the second-layer internal electrode 401 are formed in the inter-wiring-layer film 102 has been described. However, the number of layers of the internal electrodes is not limited to two layers, and any number of layers can be employed with no problem. Moreover, the slits 302 and 402 are also not limited to the example described above in the present embodiment, and optimal shapes and number may be employed in accordance with outer shape dimensions and a working method for the first-layer internal electrode 301 and the second-layer internal electrode 401.

Hereinafter, the reason why the shapes of the slits 302 of the first-layer internal electrode 301 and the slits 402 of the second-layer internal electrode 401 are formed as shown in Figs. 16 and 17 will be described in further details together with a manufacturing method therefor.

As shown in D of Fig. 18, the first-layer internal electrode 301 and the second-layer internal electrode 401 are formed of copper films (Cu) 303B and 403B, respectively. Here, the following description will be given using the first-layer internal electrode 301 as an example. It should be noted that in a case of the second-layer internal electrode 401, the reference sign "302" in Fig. 18 is replaced by "402" and "303" is replaced by "403".

As shown in A of Fig. 18, the inter-wiring-layer film 102 in which the first-layer internal electrode 301 is stacked is first formed of, for example, an oxide film of silicon dioxide. Next, as shown in B of Fig. 18, slot portions 303A are formed in the inter-wiring-layer film 102. Next, as shown in C of Fig. 18, copper (Cu) plating is applied on the surface in which the slot portions 303A are formed so that a copper film 303B is formed.

Next, the surface on which the copper film 303B is deposited is polished by chemical mechanical polishing (CMP) (hereinafter, referred to as "CMP").

By performing polishing working in this manner, the copper film 303B remains inside the slot portions 303A as shown in D of Fig. 18. The remaining copper film 303B is formed in the linear portions 303. Moreover, regions of the inter-wiring-layer film 102 which are located between the copper films 303B adjacent to each other form the slits 302.

Subsequently, the second-layer internal electrode 401 is formed above the first-layer internal electrode 301 in a similar manner, and the inter-wiring-layer film 102 is stacked.

It should be noted that as to the first-layer internal electrode 301, regions of the same base material as the inter-wiring-layer film 102 remaining in portions constituting the slits 302 are removed when the above-mentioned smaller-diameter hole 105b is formed. On the other hand, as to the second-layer internal electrode 401, the regions remain and constitute a part of the inter-wiring-layer film 102. In this manner, the first-layer internal electrode 301 is formed inside the inter-wiring-layer film 102. Moreover, the second-layer internal electrode 401 is formed in a similar manner.

Here, the reason why the linear portions 303 and the slits 302 are provided and their widths and intervals will be described. If the linear portions 303 and the slits 302 are not first provided and a plating surface of the copper film 303B is polished by CMP in a state in which the copper film 303B is formed on the entire surface of the inter-wiring-layer film 102, the center portion of the polishing surface of the copper film 303B is largely polished and recessed in some cases. It is a phenomenon that copper (Cu) of the wire material and the like are excessively removed below the surface of the surrounding dielectric film. This phenomenon is generally called dishing because the cross-section of the copper film 303B is, at its center portion, recessed like a "dish".

In view of this, in the present embodiment, the configuration in which the linear portions 303 and the slits 302 are alternately provided is employed in order to prevent the center portion of the copper film 303B from being recessed. With this configuration, in C of Fig. 18, even if the plating surface of the copper film 303B in the slot portions 303A is polished by CMP, the material constituting the inter-wiring-layer film 102 is present in the portions constituting the slits 302. Therefore, the center portion of the copper film 303B is not recessed and the entire surface is polished substantially uniformly. Therefore, no dishing occurs.

Therefore, optimal values of the number, the width, the intervals, and the like of the linear portions 303 only need to be determined in accordance with conditions such as the outer shape dimensions of the first-layer internal electrode 301 and the thickness of the copper film 303B so as to prevent the occurrence of dishing. For example, in a case where the first-layer internal electrode 301 has a lateral width dimension of 100 $\mu$m, a plurality of linear portions 303 having a lateral width of several $\mu$m only needs to be provided at predetermined intervals. The same applies to the case of the second-layer internal electrode 401.

Moreover, when the state in which the second-layer internal electrode 401 is overlapped with the first-layer internal electrode 301 is viewed from a plan perspective, the slits 302 and 402 for preventing the recessed pattern are arranged so as not to overlap each other. Therefore, when the smaller-diameter hole 105b is formed in this arrangement state, the smaller-diameter hole 105b can reach the linear portions 303 of the first-layer internal electrode 301 and can also pass through the slits 302 between the linear portions 303 and 303 and reach the linear portions 403 of the second-layer internal electrode 401. Accordingly, the redistribution layer 107 that covers the inner peripheral surface of the smaller-diameter hole 105b can connect to the linear portions 303 of the first-layer internal electrode 301 and the linear portions 403 of the second-layer internal electrode 401. Moreover, the through-hole 105 is electrically connected to the first-layer internal electrode 301 and the second-layer internal electrode 401.

In addition, by configuring the first-layer internal electrode 301 and the second-layer internal electrode 401 as described above, it is possible to prevent a decrease in film thickness due to recessed center portions of the internal electrodes 301 and 401 when the first-layer internal electrode 301 and the second-layer internal electrode 401 are formed by CMP. Therefore, in a case where the copper films 303B and 403B are used as wires in the solid-state imaging device 100, a terminal-lead out structure with the redistribution layers 107 as a chip-scale package can be realized. It should be noted that the linear portions 303 and the slits 302 may be provided in the internal electrodes 101 in the first embodiment.

Moreover, the arrays of the linear portions 303 and the slits 302 shown in Fig. 16 and the linear portions 403 and the slits 402 shown in Fig. 17 are the examples in which they are formed as vertical stripes. However, they may be formed as horizontal stripes.

Moreover, the arrays of the linear portions 303 and 403 and the slits 302 and 402 are not limited to the stripes. For example, it is conceivable that they are arranged in a grid pattern.

Since the present embodiment is configured as described above, the through-holes 105 are connectable to the plurality of internal electrodes 301 and 401 and the like. Therefore, since the number of through-holes 105 can be reduced, the occupation area of the through-holes 105 on the chip can be reduced. Accordingly, the number of elements on the chip can be improved and the chip can be downsized.

Moreover, in accordance with the present embodiment, in the solid-state imaging device 100 with the chip-scale package structure that connects the first-layer internal electrode 301 and the second-layer internal electrode 401 to the redistribution layer 107 through the through-hole 105, the through-hole 105 can be formed as the stepped hole having the step portion 105c in the silicon oxide film 104.

Moreover, such a configuration that the circumferential side surface of the smaller-diameter hole 105b of the through-hole 105 is held in close contact with the through-portion of the silicon oxide film 104 can be made. Accordingly, the distance d of the portion where the first-layer internal electrode 301 and the board silicon 103 face each other can be increased, and the parasitic capacitance Cs generated between both can be reduced. Therefore, it is possible to suppress signal delay and waveform distortion of high-frequency signals, and it is thus possible to realize high-speed operation.

<5. First Manufacturing Method for Second Embodiment of Solid-State Imaging Device Associated with Example of Present Disclosure>

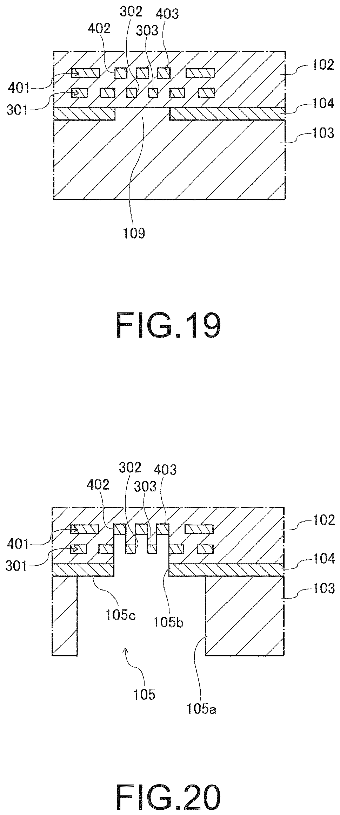

Next, a first manufacturing method for the second embodiment of the solid-state imaging device 100 associated with the example of the present disclosure will be described with reference to Figs. 19 to 23. In these figures, an example in which the first-layer internal electrode 301 and the second-layer internal electrode 401 are provided will be described.

As shown in Fig. 19, the silicon oxide film 104 is first stacked on the board silicon 103. The silicon oxide film 104 is constituted by, for example, silicon dioxide. The silicon oxide film-removed region 109 where the silicon oxide film 104 is not arranged in the region in which the smaller-diameter hole 105b of the through-hole 105 is formed is formed in the silicon oxide film 104. The silicon oxide film-removed region 109 can be formed at the same time as the silicon oxide film 104 by the oxide film formation step used in the STI, for example. Accordingly, the silicon oxide film-removed region 109 is made of the same material as the board silicon 103.

Next, the inter-wiring-layer film 102 is stacked on the silicon oxide film 104. As described above with reference to Fig. 18, the inter-wiring-layer film 102 is formed by stacking the first-layer internal electrode 301 which is the receiver for the through-hole 105 for electrically connecting to the redistribution layer 107 from below the board silicon 103 and further stacking the second-layer internal electrode 401 above the first-layer internal electrode 301. Silicon dioxide is used for the base material of the inter-wiring-layer film 102 as in the silicon oxide film 104, for example.

Next, as shown in Fig. 20, the through-hole 105 is formed toward the inter-wiring-layer film 102 from below the board silicon 103. The through-hole 105 is formed in such a manner that the larger-diameter hole 105a reaches the silicon oxide film 104 in the board silicon 103. The larger-diameter hole 105a reaches the silicon oxide film 104, and then the smaller-diameter hole 105b is formed to reach the first-layer internal electrode 301 and the second-layer internal electrode 401 in the silicon oxide film-removed region 109.

Specifically, as shown in Fig. 20, in the first-layer internal electrode 301, the through-hole 105 is formed to reach the linear portion 303. Moreover, in the second-layer internal electrode 401, the through-hole 105 is formed to pass through the slits 302 of the first-layer internal electrode 301 and reach the linear portions 403 of the second-layer internal electrode 401.

Accordingly, as the through-hole 105, the stepped hole having the step portion 105c in the silicon oxide film 104 is formed. The larger-diameter hole 105a, the smaller-diameter hole 105b, and the stepped hole having the step portion 105c can be formed by patterning with resist and etching.

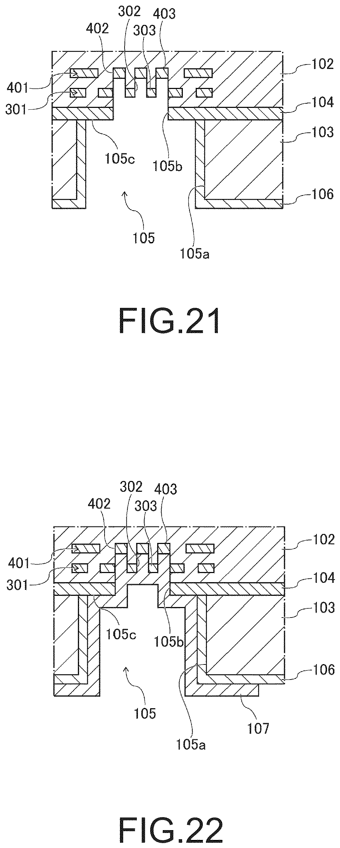

Next, as shown in Fig. 21, the interlayer dielectric film 106 is formed on the circumferential side surface of the larger-diameter hole 105a of the through-hole 105 and the lower surface of the board silicon 103. The interlayer dielectric film 106 first covers the entire lower surface of the board silicon 103 and the entire inner peripheral surfaces of the larger-diameter hole 105a and the smaller-diameter hole 105b with the dielectric film. After that, it can be formed by removing the dielectric film on the silicon oxide film 104 forming the step portion 105c and the inner peripheral surface including the first-layer internal electrode 301 and the second-layer internal electrode 401 in the smaller-diameter hole 105b by a technique such as etching back.

Next, as shown in Fig. 22, the redistribution layer 107 is formed on the entire inner peripheral surface of the through-hole 105 and the interlayer dielectric film 106. As the redistribution layer 107 on the interlayer dielectric film 106, a mask is formed with a resist material provided with an opening pattern conforming to the shape of a wire pattern in a region where wires are formed and, for example, a copper film with a film thickness of from several $\mu$m to several tens of $\mu$m is formed by electroplating. Accordingly, the first-layer internal electrode 301 and the second-layer internal electrode 401 are electrically connected to the redistribution layer 107, such that pixel data can be transmitted to the outside through the through-hole 105.

Next, as shown in Fig. 23, the solder bump 115 which is the external connection terminal connected to an external module board (not shown) is provided on the redistribution layer 107 at the opening of the through-hole 105. Moreover, the interlayer dielectric film 106, the redistribution layer 107, and the through-hole 105 are covered with the protective film 114 and the top portion of the solder bump 115 is exposed. In this manner, the solid-state imaging device 100 according to the second embodiment can be manufactured. Alternatively, the interlayer dielectric film 106, the redistribution layer 107, and the through-hole 105 may be covered with the protective film 114 and land or wire patterns for external connection may be formed on the redistribution layer 107 at the opening of the through-hole 105.

It should be noted that also in the second embodiment, it is needless to say that any shape such as a circular shape or a rectangular shape can be selected as the shape of the silicon oxide film-removed region 109 as described above in the first embodiment.

As described hereinabove, in accordance with the first manufacturing method for the second embodiment, the through-hole 105 can be formed as the stepped hole having the step portion 105c. Moreover, the circumferential side surface of the smaller-diameter hole 105b formed in the board silicon 103 can be held in close contact with the through-portion of the silicon oxide film 104. Accordingly, as shown in Fig. 23, the distance d of the portion where the first-layer internal electrode 301 and the second-layer internal electrode 401 and the board silicon 103 face each other can be increased, and the parasitic capacitance Cs generated between both can be reduced. Therefore, it is possible to suppress signal delay and waveform distortion of high-frequency signals, and it is thus possible to realize high-speed operation.

<6. Second Manufacturing Method for Second Embodiment of Solid-State Imaging Device Associated with Example of Present Disclosure>

Next, a second manufacturing method for the second embodiment of the solid-state imaging device 100 associated with the example of the present disclosure will be briefly described. The second manufacturing method for the present embodiment is different from the first manufacturing method for the second embodiment in that it does not include the step of forming the silicon oxide film-removed region 109 in the silicon oxide film 104.

Other points are similar to those of the first manufacturing method for the second embodiment, and therefore the description will be omitted.

<7. Configuration Example of Electronic Apparatus>

An application example to the electronic apparatus of the solid-state imaging device 100 according to each of the above-mentioned embodiments will be described with reference to Fig. 24. It should be noted that this application example is common to the solid-state imaging devices 100 according to the first embodiment and the second embodiment.

The solid-state imaging device 100 can be applied to general electronic apparatuses using an image capture unit (photoelectric converter), e.g., an imaging device 200 such as a digital still camera or a video camera, a portable terminal device with an imaging function, or a copying machine using the solid-state imaging device 100 as an image reading unit. The solid-state imaging device 100 may be one formed as one chip or the solid-state imaging device 100 packaged. Moreover, it may be a module with an imaging function, in which the imaging unit and the signal processing unit or the optical system are packaged together.

As shown in Fig. 24, the imaging device 200 as the electronic apparatus includes an optical unit 202, the solid-state imaging device 100, a digital signal processor (DSP) circuit 203 which is a camera signal processing circuit, a frame memory 204, a display unit 205, a recording unit 206, an operation unit 207, and a power supply unit 208. The DSP circuit 203, the frame memory 204, the display unit 205, the recording unit 206, the operation unit 207, and the power supply unit 208 are connected to one another via a bus line 209 constituted by a signal line and a power supply line.

The optical unit 202 includes a plurality of lenses, and takes in incident light (image light) from an object to be imaged and forms an image on an imaging plane of the solid-state imaging device 100. The solid-state imaging device 100 converts the amount of light of the incident light formed as the image on the imaging plane by the optical unit 202 into electrical signals on a pixel-by-pixel basis and outputs them as pixel signals.

The display unit 205 is a panel-type display device, for example, a liquid-crystal panel or an organic electro luminescence (EL) panel, and displays a moving image or a still image captured by the solid-state imaging device 100. The recording unit 206 records the moving image or the still image captured by the solid-state imaging device 100 on a recording medium such as a hard disk or a semiconductor memory.

Operated by the user, the operation unit 207 issues an operation command regarding various functions of the imaging device 200. The power supply unit 208 supplies various power supplies which are operation power supplies for the DSP circuit 203, the frame memory 204, the display unit 205, the recording unit 206, and the operation unit 207 to those supply targets as appropriate.

In accordance with the imaging device 200 as described above, reductions in size and weight can be achieved in order to use the solid-state imaging device 100 reduced in thickness and size. Moreover, since the number of elements on the chip can be increased, a high-quality captured image can be obtained.

Last of all, the descriptions of each of the above-mentioned embodiments are examples of the present disclosure, and the present disclosure is not limited to the above-mentioned embodiments. Therefore, even other than each of the above-mentioned embodiments, various modifications can be made in accordance with the design and the like as a matter of course without departing from the technical ideas associated with the present disclosure. Moreover, the effects described in the present specification are merely examples, and the present technology is not limited thereto, and other effects may be provided.

It should be noted that the present technology can also take the following configurations.

(1) A semiconductor device, including:

a board silicon;
a silicon oxide film stacked on the board silicon;
an inter-wiring-layer film having an internal electrode stacked on the silicon oxide film;
a through-hole forming a stepped hole with a larger-diameter hole extending from the board silicon to the silicon oxide film and a smaller-diameter hole extending from the silicon oxide film to the internal electrode;
an interlayer dielectric film stacked on a circumferential side surface of the larger-diameter hole and the board silicon; and
a redistribution layer formed on an inner peripheral surface of the through-hole and the interlayer dielectric film and connected to the internal electrode.

(2) The semiconductor device according to (1), in which

a circumferential side surface of the smaller-diameter hole is held in close contact with a through-portion of the silicon oxide film.

(3) The semiconductor device according to (1) or (2), in which the internal electrode is formed of a copper film.

(4) The semiconductor device according to any one of (1) to (3), in which

a plurality of slits is formed in the internal electrode.

(5) The semiconductor device according to any one of (1) to (4), in which

the internal electrodes in at least two layers are stacked inside the inter-wiring-layer film.

(6) The semiconductor device according to (5), in which

the plurality of internal electrodes stacked inside the inter-wiring-layer film is stacked in such a manner that the slits do not overlap each other.

(7) The semiconductor device according to any one of (1) to (6), in which

a connection surface between the smaller-diameter hole and the internal electrode is formed in a circular shape.

(8) The semiconductor device according to any one of (1) to (7), in which

a connection surface between the smaller-diameter hole and the internal electrode is formed in a rectangular shape.

(9) The semiconductor device according to any one of (1) to (7), in which

the redistribution layer has a solder bump provided at an opening of the through-hole.

(10) The semiconductor device according to any one of (1) to (9), in which

the semiconductor device is a solid-state imaging device.

(11) A manufacturing method for a semiconductor device, including:

a step of stacking a silicon oxide film on a board silicon and stacking an inter-wiring-layer film having an internal electrode on the silicon oxide film;

a step of forming a through-hole that is a stepped hole with a larger-diameter hole extending from the board silicon to the silicon oxide film and a smaller-diameter hole extending from the silicon oxide film to the internal electrode;

a step of forming an interlayer dielectric film on a circumferential side surface of the through-hole of the board silicon and the board silicon;

a step of forming a redistribution layer on an inner peripheral surface of the through-hole and the interlayer dielectric film; and

a step of covering the interlayer dielectric film, the redistribution layer, and the through-hole with a protective film.

(12) The manufacturing method for a semiconductor device according to (11), in which

the step of stacking the silicon oxide film on the board silicon includes a step of forming a silicon oxide film-removed region that is a region where the smaller-diameter hole is formed in the silicon oxide film.

(13) The manufacturing method for a semiconductor device according to (11) or (12), in which

the step of forming the redistribution layer includes a step of providing a solder bump to the redistribution layer at an opening of the through-hole.

(14) The manufacturing method for a semiconductor device according to any one of (11) to (13), in which the step of forming the inter-wiring-layer film having the internal electrode includes a step of stacking the internal electrodes in a plurality of layers.

(15) The manufacturing method for a semiconductor device according to any one of (11) to (14), in which the step of forming the inter-wiring-layer film having the internal electrode includes

a step of forming a slot portion in the inter-wiring-layer film,

a step of depositing a copper film on a surface in which the slot portion is formed, and

a step of polishing a surface in which the slot portion is formed in such a manner that the copper film remains in the slot portion.

(16) An electronic apparatus, including
a semiconductor device including

a board silicon,

a silicon oxide film stacked on the board silicon,

an inter-wiring-layer film having an internal electrode stacked on the silicon oxide film,

a through-hole forming a stepped hole with a larger-diameter hole extending from the board silicon to the silicon oxide film and a smaller-diameter hole extending from the silicon oxide film to the internal electrode,

an interlayer dielectric film stacked on a circumferential side surface of the larger-diameter hole and the board silicon, and

a redistribution layer that is formed on an inner peripheral surface of the through-hole and the interlayer dielectric film and is connected to the internal electrode.

Reference Signs List

| | |
|---|---|
| 100 | solid-state imaging device |
| 101 | internal electrode |
| 102 | inter-wiring-layer film |

| 103 | board silicon |
|-----|---------------|
| 104 | silicon oxide film |
| 105 | through-hole |
| 105a | larger-diameter hole |
| 105b | smaller-diameter hole |
| 105c | step portion |
| 106 | interlayer dielectric film |
| 107 | redistribution layer |
| 109 | silicon oxide film-removed region |
| 110 | photoelectric converter |
| 111 | dielectric film |
| 112 | bonding resin |
| 113 | light-transmissive substrate |
| 114 | protective film |
| 115 | solder bump |
| 116 | color filter |
| 117 | on-chip lens |
| 118 | photodiode forming layer |
| 120 | sensor board |
| 130 | logic board |
| 150 | through-hole portion |
| 200 | imaging device |
| 301 | first-layer internal electrode |
| 302 | slit |
| 303 | linear portion |
| 303A | slot portion |
| 303B | copper film |
| 401 | second-layer internal electrode |
| 402 | slit |
| 403 | linear portion |
| 403B | copper film |
| Cs | parasitic capacitance |
| S | area |
| d | distance |
| ε | permittivity |

**Claims**

1. A semiconductor device, comprising:

   a board silicon;
   a silicon oxide film stacked on the board silicon;
   an inter-wiring-layer film having an internal electrode stacked on the silicon oxide film;
   a through-hole forming a stepped hole with a larger-diameter hole extending from the board silicon to the silicon oxide film and a smaller-diameter hole extending from the silicon oxide film to the internal electrode;
   an interlayer dielectric film stacked on a circumferential side surface of the larger-diameter hole and the board silicon; and
   a redistribution layer formed on an inner peripheral surface of the through-hole and the interlayer dielectric film and connected to the internal electrode.

2. The semiconductor device according to claim 1, wherein
   a circumferential side surface of the smaller-diameter hole is held in close contact with a through-portion of the silicon oxide film.

3. The semiconductor device according to claim 1, wherein
   the internal electrode is formed of a copper film.

4. The semiconductor device according to claim 1, wherein
   a plurality of slits is formed in the internal electrode.

5. The semiconductor device according to claim 1, wherein
   the internal electrodes in at least two layers are stacked inside the inter-wiring-layer film.

6. The semiconductor device according to claim 5, wherein
   the plurality of internal electrodes stacked inside the inter-wiring-layer film is stacked in such a manner that the slits do not overlap each other.

7. The semiconductor device according to claim 1, wherein
   a connection surface between the smaller-diameter hole and the internal electrode is formed in a circular shape.

8. The semiconductor device according to claim 1, wherein
   a connection surface between the smaller-diameter hole and the internal electrode is formed in a rectangular shape.

9. The semiconductor device according to claim 1, wherein
   the redistribution layer has a solder bump provided at an opening of the through-hole.

10. The semiconductor device according to claim 1, wherein
    the semiconductor device is a solid-state imaging device.

11. A manufacturing method for a semiconductor device, comprising:

    a step of stacking a silicon oxide film on a board silicon and stacking an inter-wiring-layer film having an internal electrode on the silicon oxide film;
    a step of forming a through-hole that is a stepped hole with a larger-diameter hole extending from the board silicon to the silicon oxide film and a smaller-diameter hole extending from the silicon oxide film to the internal electrode;
a step of forming an interlayer dielectric film on a circumferential side surface of the through-hole of the board silicon and the board silicon;
a step of forming a redistribution layer on an inner peripheral surface of the through-hole and the interlayer dielectric film; and
a step of covering the interlayer dielectric film, the redistribution layer, and the through-hole with a protective film.

12. The manufacturing method for a semiconductor device according to claim 11, wherein
the step of stacking the silicon oxide film on the board silicon includes a step of forming a silicon oxide film-removed region that is a region where the smaller-diameter hole is formed in the silicon oxide film.

13. The manufacturing method for a semiconductor device according to claim 11, wherein
the step of forming the redistribution layer includes a step of providing a solder bump to the redistribution layer at an opening of the through-hole.

14. The manufacturing method for a semiconductor device according to claim 11, wherein
the step of forming the inter-wiring-layer film having the internal electrode includes a step of stacking the internal electrodes in a plurality of layers.

15. The manufacturing method for a semiconductor device according to claim 11, wherein
the step of forming the inter-wiring-layer film having the internal electrode includes

a step of forming a slot portion in the inter-wiring-layer film,
a step of depositing a copper film on a surface in which the slot portion is formed, and
a step of polishing a surface in which the slot portion is formed in such a manner that the copper film remains in the slot portion.

16. An electronic apparatus, comprising
a semiconductor device including

a board silicon,
a silicon oxide film stacked on the board silicon,
an inter-wiring-layer film having an internal electrode stacked on the silicon oxide film,
a through-hole forming a stepped hole with a larger-diameter hole extending from the board silicon to the silicon oxide film and a smaller-diameter hole extending from the silicon oxide film to the internal electrode,
an interlayer dielectric film stacked on a circumferential side surface of the larger-diameter hole and the board silicon, and

a redistribution layer that is formed on an inner peripheral surface of the through-hole and the interlayer dielectric film and is connected to the internal electrode.

FIG.1

FIG.2

FIG.3

FIG.4

101

102

104

103

105c 105b

106

105a

105

## FIG.5

101

102

104

103

105c 105b

106

105a

105 107

## FIG.6

FIG.7

FIG.8

FIG.9

FIG.10

FIG.11

FIG.12

FIG.13

FIG.14

FIG.15

FIG.16

FIG.17

FIG.18

FIG.19

FIG.20

FIG.21

FIG.22

FIG.23

FIG.24

FIG.25

## INTERNATIONAL SEARCH REPORT

International application No.

**PCT/JP2022/036110**

| A. | CLASSIFICATION OF SUBJECT MATTER |
|---|---|

***H01L 21/3205***(2006.01)i; ***H01L 21/768***(2006.01)i; ***H01L 23/522***(2006.01)i; ***H01L 27/146***(2006.01)i
FI:  H01L21/88 J; H01L21/88 T; H01L27/146 D

According to International Patent Classification (IPC) or to both national classification and IPC

| B. | FIELDS SEARCHED |
|---|---|

Minimum documentation searched (classification system followed by classification symbols)

H01L21/3205; H01L21/768; H01L23/522; H01L27/146

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2009-158862 A (TOSHIBA CORP.) 16 July 2009 (2009-07-16)<br>paragraph [0015], fig. 2-18 | 1-16 |
| Y | JP 2021-27302 A (CANON INC.) 22 February 2021 (2021-02-22)<br>fig. 1 | 1-16 |
| Y | JP 2012-243953 A (PANASONIC CORP.) 10 December 2012 (2012-12-10)<br>paragraph [0063], fig. 1-7, 13, 14 | 3-6, 14, 15 |
| Y | JP 2015-198162 A (DENSO CORP.) 09 November 2015 (2015-11-09)<br>fig. 2, 3 | 12 |
| A | JP 2010-186870 A (TOSHIBA CORP.) 26 August 2010 (2010-08-26) | 1-16 |
| A | JP 2014-13810 A (SEIKO EPSON CORP.) 23 January 2014 (2014-01-23) | 1-16 |

☐ Further documents are listed in the continuation of Box C.    ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **22 November 2022** | **06 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/036110**

| Patent document cited in search report | | | Publication date (day/month/year) | Patent family member(s) | | | Publication date (day/month/year) |
|---|---|---|---|---|---|---|---|
| JP | 2009-158862 | A | 16 July 2009 | US | 2009/0283847 | A1 | |
| | | | | paragraph [0039], fig. 2-18 | | | |
| | | | | WO | 2009/084700 | A1 | |
| | | | | KR | 10-2009-0104127 | A | |
| | | | | TW | 200937605 | A | |
| JP | 2021-27302 | A | 22 February 2021 | US | 2021/0043562 | A1 | |
| | | | | fig. 1 | | | |
| JP | 2012-243953 | A | 10 December 2012 | (Family: none) | | | |
| JP | 2015-198162 | A | 09 November 2015 | (Family: none) | | | |
| JP | 2010-186870 | A | 26 August 2010 | (Family: none) | | | |
| JP | 2014-13810 | A | 23 January 2014 | US | 2014/0008816 | A1 | |
| | | | | KR | 10-2014-0005107 | A | |
| | | | | CN | 103531553 | A | |
| | | | | TW | 201403780 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010251558 A